# EUROPÄISCHE PATENTSCHRIFT

(11) **EP 0 725 484 B1**
(45) Veröffentlichungstag und Bekanntmachung des Hinweises auf die Patenterteilung: **01.12.1999**
(21) Anmeldenummer: 96100367.0
(22) Anmeldetag: 11.01.1996
(51) Int. Cl.: H03L 7/085

(54) **Verfahren und Anordnung zum Ermitteln der Phasendifferenz zwischen Taktsignalen in einer Kommunikationseinrichtung**
Process and arrangement for determining the phase difference between clock signals in communications equipment
Procédé et dispositif pour déterminer la différence de phase de signaux d'horloge dans un dispositif de communication

(30) Priorität: 31.01.1995 DE 19503035
(43) Veröffentlichungstag der Anmeldung: 07.08.1996
(73) Patentinhaber: SIEMENS AKTIENGESELLSCHAFT, 80333 München (DE)
(72) Erfinder: Zwack, Eduard, Dipl.-Ing., D-82178 Puchheim (DE)

(56) Entgegenhaltungen:
- EP-A- 0 043 407
- EP-A- 0 237 699
- EP-A- 0 389 662

## Beschreibung

In synchron betriebenen Kommunikationseinrichtungen ist zentral eine hochgenaue, ausfallgesicherte Taktgeneratoreinrichtung installiert. Die in dieser Taktgeneratoreinrichtung erzeugten Taktsignale werden über übertragungstechnische Einrichtungen zusammen mit den zu übermittelnden digitalen Informationen, z.B. Sprachinformationen, an alle Komponenten eines Kommunikationsnetzes verteilt. Mit Hilfe von mit Phasenregelkreisen - Phase Locked Loop - ausgestatteten Taktgeneratoreinrichtungen werden in den Komponenten jeweils Taktsignale generiert, deren Phasen mit den Phasen der ankommenden hochgenauen Referenztaktsignale - sind die verteilten Taktsignale - übereinstimmen.

Eine Taktgeneratoreinrichtung mit einem Phasenregelkreis ist aus der europäischen Patentschrift EP 0 389 662 B1 bekannt. In der Taktgeneratoreinrichtung werden mit Hilfe eines durch eine Phasenmeßeinrichtung und eine Steuereinrichtung gebildeten Phasenregelkreises die in einem spannungsgesteuerten Taktoszillator gebildeten Taktsignale hinsichtlich ihrer Phase bzw. Frequenz mit den ankommenden Referenztaktsignalen synchronisiert. In der Phasenmeßeinrichtung wird die Phasendifferenz zwischen den Taktsignalen und den Referenztaktsignalen mit Hilfe einer Zähleinrichtung, eine durch hintereinandergeschaltete Verzögerungselemente gebildeten Verzögerungsleitung sowie eines Zähl- und Laufzeitregisters ermittelt. Hierbei werden die Taktsignale in einer Zähleinrichtung gezählt sowie jeweils der aktuelle Zählerstand in ein zu durch die Referenztaktsignale bestimmten und auf die Taktsignale synchronisierten Zeitpunkten - beispielsweise bei der positiven Signal flanke - in ein Zählregister übernommen.

Die Referenztaktsignale durchlaufen die hintereinandergeschalteten Verzögerungselemente der Verzögerungsleitung, wobei jeweils zu durch das folgende Taktsignal bestimmten Zeitpunkten eine die Anzahl der vom Referenztaktsignal durchlaufenen Verzögerungselemente repräsentierende Laufzeitinformation in ein Laufzeitregister übernommen wird. Mit Hilfe des Zählerstandes und der Laufzeitinformation wird in der Steuereinrichtung die Phasendifferenz berechnet, wobei von der Differenz des aktuellen zum vorhergehenden Zählerstand die Phasendifferenz in Taktsignalperioden - d.h. die Phasengrobdifferenz - und von der Laufzeitinformation die Phasendifferenz innerhalb einer Taktsignalperiode - d.h. die Phasenfeindifferenz - bestimmt ist. Die Grob- und Feinphasendifferenz bilden zusammen die Phasendifferenz zwischen den Taktsignalen und den Referenztaktsignalen. Die Berechnung der Phasendifferenz erfolgt mit Hilfe eines in der Steuereinrichtung implementierten Programms.

Die Verzögerungsleitung ist durch mehrere Verzögerungselemente gebildet. Eine derart gebildete Laufzeitkette ist beispielsweise aus der europäischen Veröffentlichungsschrift 0 274 606 bekannt. Hierbei sind die Verzögerungselemente bzw. Laufzeitglieder durch n- und p- Kanal- Feldeffekttransistoren und daraus gebildeten Invertern realisiert. Aufgrund der Bauteiletoleranzen, insbesondere der Halbleiter-Bauteiletoleranzen, weisen die Verzögerungselemente bis zu einem Faktor 4 unterschiedliche Laufzeiten - beispielsweise zwischen 0.5 bis 2 ns - auf. Da die Laufzeitinformation durch die Anzahl der durchlaufenen Verzögerungselemente repräsentiert ist, ergeben sich bei der Ermittlung der Phasenfeindifferenz, bei der die Anzahl der durchlaufenen Verzögerungselemente mit der Laufzeit eines Verzögerungselementes multipliziert wird, erhebliche Unterschiede zwischen der ermittelten, d.h. berechneten, und der tatsächlichen Laufzeit des Referenztaktsignals in der Verzögerungsleitung. Dies wird im wesentlichen dadurch verursacht, daß für die Ermittlung bzw. Berechnung ein Laufzeitmittelwert vorgesehen ist, der in etwa zwischen den durch die Bauteiletoleranzen verursachten, tatsächlichen Minimal- und Maximallaufzeiten liegt.

Die der Erfindung zugrundeliegende Aufgabe ist darin zu sehen, das bekannte Verfahren zur Ermittlung der Phasendifferenz, insbesondere hinsichtlich der Genauigkeit der Phasenfeindifferenz zwischen Taktsignalen und Referenztaktsignalen zu verbessern. Die Aufgabe wird ausgehend von dem bekannten Verfahren zum Ermitteln der Phasendifferenz zwischen einem Taktsignal und einem Referenztaktsignal gemäß den Merkmalen des Oberbegriffs des Anspruchs 1 durch dessen kennzeichnende Merkmale gelöst.

Der wesentliche Aspekt des erfindungsgemäßen Verfahrens ist darin zu sehen, daß mit Hilfe eines weiteren Laufzeitregisters, d.h. eines Zwischenspeichers, die Anzahl der von einem Referenztaktsignal, d.h. der Signalflanke eines Referenztaktsignals, durchlaufenen Verzögerungselemente während einer Periode des Taktsignals ermittelt und in diesem gespeichert wird. Da die Dauer einer Periode eines Taktsignals - beispielsweise 100 ns - präzise bestimmt ist, kann durch eine Division der Dauer einer Periode eines Taktsignals durch die Anzahl der festgestellten durchlaufenen Verzögerungselemente die absolute Laufzeit eines Verzögerungselementes präzise ermittelt werden. Durch eine Multiplikation der absoluten Laufzeit eines Verzögerungselementes mit der festgestellten Anzahl von durchlaufenen Verzögerungselementen ist die Gesamtlaufzeit eines Referenztaktsignals bzw. deren Signalflanke vom Beginn eines Referenztaktsignals bis zum folgenden Beginn eines Taktsignals - durch deren Signalflanke repräsentiert - bestimmt. Bezogen auf eine Periode eines Taktsignals kann daraus die Phasendifferenz berechnet werden. Durch das erfindungsgemäße Verfahren kann vorteilhaft die absolute Laufzeit eines Verzögerungselementes erheblich präziser bestimmt und damit die Phasendifferenz - insbesondere die Phasenfeindifferenz - erheblich präziser berechnet werden. Dies bedeutet in einem Phasenregelkreis ein wesentlich präziseres Synchronisieren von Taktsignalen auf Referenztaktsignale, da eine das erfindungsgemäße Verfahren realisierende Phasendifferenz-Meßeinrichtung eine erheblich größere Auflösung, d.h. erheblich bessere Genauigkeit aufweist.

Weitere vorteilhafte Ausgestaltungen des erfindungsgemäßen Verfahrens sowie eine vorteilhafte Anordnung zur Durchführung des erfindungsgemäßen Verfahrens sind den weiteren Ansprüchen zu entnehmen.

Im folgenden wird das erfindungsgemäße Verfahren anhand eines Blockschaltbildes näher erläutert.

Das Blockschaltbild zeigt eine Phasenmeßeinrichtung PME - durch strichpunktierte Linien umfaßt -, die durch eine Zähleinrichtung ZE, ein Zählregister ZR, eine Verzögerungsleitung VZL, einen Dezimal-Binär-Wandler DBW, ein Laufzeitregister LZR sowie ein weiteres Laufzeitregister WLZR, ein UND-Verknüpfungsglied U, eine erste sowie zweite Kippstufe KS1, KS2 und teilweise durch einen Mikroprozessor MP gebildet ist. Ein erster Eingang El der Phasenmeßeinrichtung PME ist mit einem Eingang E der Zähleinrichtung ZE sowie jeweils mit einem Takteingang TE der beiden Kippstufen KS1, KS2 verbunden. Über diesen ersten Eingang El gelangen Taktsignale ts mit beispielsweise einer Dauer einer Periode von 100 ns an die Takteingänge TE der beiden Kippstufen KS1, KS2 und an den Eingang E der Zähleinrichtung ZE. Die Ausgänge A der Zähleinrichtung ZE sind mit Eingängen E des Zählregisters ZR verbunden. An den Ausgängen A der Zähleinrichtung ZE liegen die Zählerstände zs der in der Zähleinrichtung ZE gezählten Taktsignale ts vor. Beispielsweise ist der Zählerstand zs an 20 Ausgängen, d.h. 20 Bit der Zähleinrichtung ZE repräsentiert. Dies bedeutet, daß die Zähleinrichtung ZE über 20 Leitungen L mit dem Zählregister ZR verbunden ist.

Ein zweiter Eingang E2 der Phasenmeßeinrichtung PME ist an einen Eingang D der ersten Kippstufe KS1 - beispielsweise den D-Eingang der Kippstufe KS1 - und an einen Eingang des UND-Verknüpfungsgliedes U geführt. Der Ausgang Q der ersten Kippstufe KS1 ist mit einem Eingang D der zweiten Kippstufe KS2 verbunden und der invertierende Ausgang Q' der ersten Kippstufe ist mit einem weiteren Eingang des UND-Verknüpfungsgliedes U verbunden. Der Ausgang des UND-Verknüpfungsgliedes U ist auf einen Eingang der Verzögerungsleitung VZL geschaltet. Die Verzögerungsleitung VZL weist seriell geschaltete Verzögerungselemente VE, eine Laufzeitkette bildend, auf. Die einzelnen Verzögerungselemente VE bzw. Laufzeitglieder sind beispielsweise durch n- und p-Kanal-Feldeffekttransistoren und daraus gebildeten Invertern realisiert. Eine derart gebildete Laufzeitkette ist aus der europäischen Veröffentlichungsschrift 0 274 606 bekannt. Für das Ausführungsbeispiel sei angenommen, daß die Verzögerungsleitung VZL durch 200 Verzögerungselemente gebildet ist, wobei jedes Verzögerungselement VE aufgrund von Bauteiletoleranzen eine absolute Laufzeit von 0,5 bis 2 ns aufweisen kann. Bei minimaler Verzögerungszeit von 0,5 ns je Verzögerungselement beträgt die Laufzeit einer Signalflanke bzw. eines Signals durch die Verzögerungsleitung 100 ns. Da die Dauer einer Periode eines Taktsignals ts ebenfalls 100 ns umfaßt, kann die Laufzeit einer Signalflanke bzw. eines Signals innerhalb einer Periode eines Taktsignals ts ermittelt werden. Die 200 jeweils zwischen den Verzögerungselementen VE vorgesehenen Ausgänge - nicht detailliert dargestellt - der Verzögerungsleitung VZL sind an einen Dezimal-Binär-Wandler DBW geführt, in dem in Abhängigkeit von an den Ausgängen der Verzögerungselemente VE vorliegenden binären Informationen i codierte binäre Informationen cd gebildet und über Ausgänge A des Dezimal-Binär-Wandlers DBW an das weitere Laufzeitregister WZR übermittelt werden. Die im weiteren Laufzeitregister WLZR gespeicherten Informationen cd können über durch einen Pfeil angedeutete Verbindungen von dem Mikroprozessor MP im Sinne der Weiterverarbeitung gelesen werden.

Des weiteren weist dieses weitere Laufzeitregister WLZR einen Übernahmeeingang UE auf, der mit dem Ausgang Q der zweiten Kippstufe KS2 verbunden ist.

Der invertierende Ausgang Q' der ersten Kippstufe KS1 ist zusätzlich mit einem Übernahmeeingang UE des Laufzeitregisters LZR und einem Übernahmeeingang UE des Zählregisters ZR verbunden. Die Ausgänge A des Dezimal-Binär-Wandlers DBW sind zusätzlich zum weiteren Laufzeitregister WZL parallel an das Laufzeitregister LZR geführt. Die in dem Laufzeitregister LZR gespeicherten Informationen sind analog wie beim weiteren Laufzeitregister LZR über durch einen Pfeil angedeutete Verbindungen vom Mikroprozessor MP im Sinne einer Weiterverarbeitung lesbar.

Die am ersten Eingang El ankommenden Taktsignale ts werden in der Zähleinrichtung ZE kontinuierlich gezählt. Ein am zweiten Eingang E2 ankommendes Referenztaktsignal rts - beispielsweise durch eine positive Flanke repräsentiert - gelangt an den Eingang D der ersten Kippstufe KS1 und an das UND-Verknüpfungsglied U. Mit der Flanke - beispielsweise positiven Flanke - des folgenden Taktsignals TS gelangt der Flankenwechsel des Referenztaktsignals rts über den Ausgang Q an den Eingang D der zweiten Kippstufe KS2. Der invertierende Ausgang Q' der ersten Kippstufe KS1 weist bis zum Ankommen beispielsweise der positiven Flanke des Taktsignals ts High-Potential auf. Dies bedeutet, daß mit der ankommenden positiven Flanke des Referenztaktsignals rts beide Eingänge des UND-Verknüpfungsgliedes U High-Potential aufweisen und der Ausgang des UND-Verknüpfungsgliedes U auf High-Potential gesteuert wird. Die positive Flanke des Referenztaktsignals rts wird dadurch an den Eingang E der Verzögerungsleitung E gesteuert und durchläuft die Verzögerungsleitung VZL sukzessive. Hierbei wechseln die Ausgänge der Verzögerungsleitung VZL ständig ihr Potential bzw. die Informationen i, wobei durch den Dezimal-Binär-Wandler diese Informationen i ständig in codierte Informationen cd umgewandelt werden. Diese codierte Informationen cd repräsentieren jeweils die Anzahl der durchlaufenen Verzögerungselemente VE in beispielsweise binärer oder hexadezimaler Form. Mit dem Ankommen der beispielsweise positiven Flanke des Taktsignals ts wechselt - wie bereits erläutert - der invertierende Ausgang Q' der ersten Kippstufe KS1 vom High-Potential auf Low-Potential. Dieser Flanken- bzw. Potentialwechsel bewirkt, daß die am Ausgang A des Dezimal-Binär-Wandlers DBW vorliegende codierte Information cd in das Laufzeitregister LZR übernommen wird. Die aktuell übernommene codierte Information cd repräsentiert die Anzahl von durchlaufenen Verzögerungselementen VE vom Signalwechsel des ankommenden Referenztaktsignals rts bis zum Signalwechsel des folgenden Taktsignals ts.

Mit dem Ankommen des Flankenwechsels des dem vorhergehend erläuternden Taktsignals ts folgenden Taktsignals ts wird der Flankenwechsel des vorhergehend erläuterten Referenztaktsignals rts' an den Ausgang Q der zweiten Kippstufe KS2 gesteuert. Durch diesen Flankenwechsel des Referenztaktsignals rts' wird eine Übernahme der an den Ausgängen A des Dezimal-Binär-Wandlers vorliegenden kodierten Information cd in das weitere Laufzeitregister WLZR bewirkt. Die nun im weiteren Laufzeitregister WLZR gespeicherte codierte Information cd repräsentiert die Anzahl der vom Flankenwechsel des Referenztaktsignals rts durchlaufenen Verzögerungselemente VE während einer Periode des Taktsignals ts. Sind beispielsweise bei der Periodendauer des Taktsignals ts von 100 ns 125 Verzögerungselemente VE durchlaufen, so weist ein Verzögerungselement VE eine absolute Laufzeit von 100 ns dividiert durch 125 Verzögerungselemente, d.h. 0,8 ns auf. Diese Berechnung wird durch Auslesen der kodierten Information cd aus dem weiteren Laufzeitregister WLZR im Mikroprozessor MP durchgeführt, wobei die Dauer einer Periode des Taktsignals ts - beispielsweise 100 ns - im Mikroprozessor MP gespeichert ist. Basierend auf der berechneten absoluten Laufzeit eines Verzögerungselementes VE kann mit Hilfe der im Laufzeitregister LZR gespeicherten kodierten Information cd die Phasendifferenz innerhalb einer Periode des Taktsignals ts im Mikroprozessor MP ermittelt werden. Hierbei wird die durch die codierte Information cd angegebene Anzahl der durchlaufenen Verzögerungselemente VE mit der absoluten Laufzeit eines Verzögerungselementes VE multipliziert und eine Gesamtlaufzeit ermittelt, mit deren Hilfe bezogen auf die Dauer der Periode eines Taktsignals ts die Phasendifferenz innerhalb eines Taktsignals ts berechnet wird. Die innerhalb eines Taktsignals ts ermittelte Phasendifferenz wird mit Phasenfeindifferenz bezeichnet.

Der am invertierenden Ausgang Q' der ersten Kippstufe KS1 auftretende Flankenwechsel des Referenztaktsignals rts' bewirkt des weiteren die Übernahme des aktuellen Zählerstandes zs der Zähleinrichtung ZE in das Zählregister ZR. Dieser aktuelle Zählerstand zs wird vom Mikroprozessor MP gelesen und durch Vergleich mit dem vorhergehenden Zählerstand zs des vorhergehenden Referenztaktsignals rts werden die abweichenden Perioden von Taktsignalen ts hinsichtlich der Phasenabweichung ermittelt. Hierbei wird demzufolge die Phasendifferenz in Anzahl von Taktperioden des Taktsignals ts ermittelt. Diese Phasendifferenz wird mit Phasengrobdifferenz bezeichnet. Durch Summieren der Grob- und Phasenfeindifferenz wird die Gesamtphasenabweichung der Taktsignale ts und der Referenztaktsignale rts im Mikroprozessor MP berechnet. Die derart ermittelte Phasendifferenz weist aufgrund der Ermittlung der absoluten Laufzeit der Verzögerungselemente VE eine sehr hohe Genauigkeit bzw. Auflösung auf. Folglich ist das erfindungsgemäße Verfahren in Phasenmeßeinrichtungen PME von hochgenauen Phasenregelkreisen einsetzbar. Derartige hochgenaue Phasenregelkreise sind in Takteinrichtungen von Kommunikationseinrichtungen, insbesondere digitalen, prozessorgesteuerten Vermittlungsanlagen vorgesehen. Darüber hinaus ist das erfindungsgemäße Verfahren in allen Kommunikationseinrichtungen einsetzbar, in denen mit Hilfe von ankommenden hochpräzisen Referenztaktsignalen hochgenaue Phasenregelkreise synchronisiert werden.

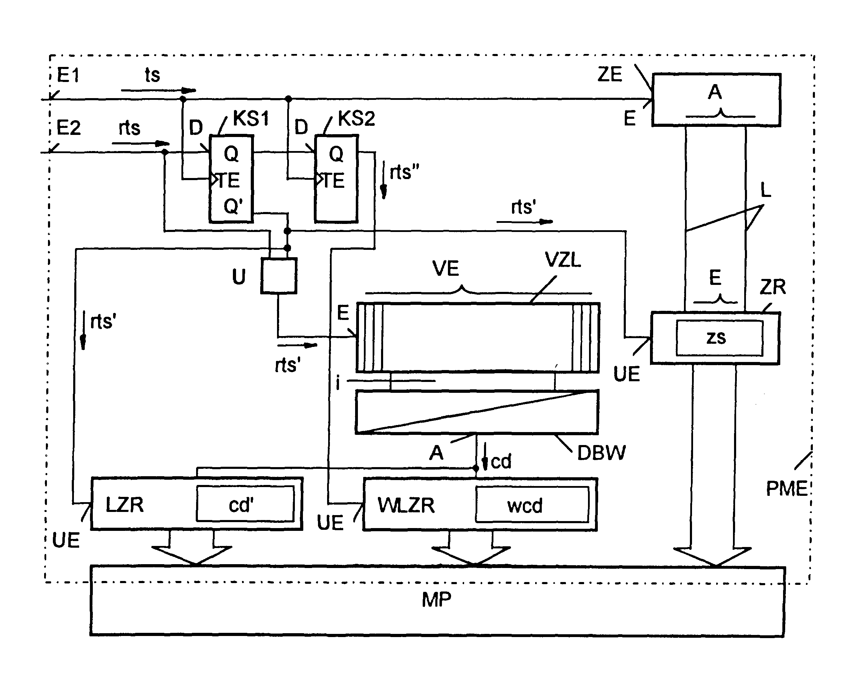

## Patentansprüche

1. Verfahren zum Ermitteln der Phasendifferenz zwischen einem Taktsignal (ts) und einem Referenztaktsignal (rts),
- bei dem die Taktsignale (ts) in einer Zähleinrichtung (ZE) gezählt werden,
- bei dem jeweils der aktuelle Zählerstand (zs) zu durch die Referenztaktsignale (rts) bestimmten und auf die Taktsignale (ts) synchronisierten Zeitpunkten in ein Zählregister (ZR) übernommen wird,
- bei dem die Referenztaktsignale (rts) hintereinandergeschaltete Verzögerungselemente (VE) einer Verzögerungsleitung (VZL) durchlaufen,
- bei dem jeweils zu durch das folgende Taktsignal (ts) bestimmten Zeitpunkten eine die Anzahl der vom Referenztaktsignal (rts) durchlaufenen Verzögerungselemente (VE) repräsentierende Laufzeitinformation (cd') in ein Laufzeitregister (LZR) übernommen wird,
dadurch **gekennzeichnet**,
- daß eine weitere, die Anzahl während einer Periode des Taktsignals (rts) durchlaufenen Verzögerungselemente (VE) repräsentierende Laufzeitinformation (wcd) in ein weiteres Laufzeitregister (WLZR) übernommen wird,
- daß mit Hilfe der weiteren Laufzeitinformationen (wcd) und der Dauer einer Periode des Taktsignals (ts) die absolute Laufzeit eines Verzögerungselementes (VE) ermittelt wird,
- daß mit Hilfe der absoluten Laufzeit eines Verzögerungselementes (VE) die absolute Laufzeitinformation (cd') ermittelt wird, und
- daß mit Hilfe des gespeicherten Zählerstandes (zs) und der absoluten Laufzeitinformation (cd') die Phasendifferenz ermittelt wird.

2. Verfahren nach Anspruch 1,
dadurch **gekennzeichnet**,
daß die absolute Laufzeit eines Verzögerungselementes (VE) durch eine Division der vorgegebenen Dauer der Periode eines Taktsignals (ts) durch die Anzahl der durch die weitere Laufzeitinformation (wcd) repräsentierte Anzahl von Verzögerungselementen (VE) bestimmt ist.

3. Verfahren nach Anspruch 1 oder 2,
dadurch **gekennzeichnet**,
- daß durch Subtraktion des aktuellen vom vorhergehenden Zählerstand (zs) die durch Perioden des Taktsignal (ts) repräsentierte Phasengrobdifferenz von einem Taktsignal (ts) zu einem Referenztaktsignal (rts) bestimmt ist,
- daß durch Multiplikation der absoluten Laufzeit eines Verzögerungselementes (VE) mit der Anzahl der durch die Laufzeitinformation (cd') repräsentierte Anzahl von Verzögerungselementen (VE) die Phasenfeindifferenz innerhalb einer Periode des Taktsignal (ts) bestimmt ist, und
- daß die Phasendifferenz zwischen den Taktsignalen (ts) und den Referenztaktsignalen (rts) jeweils durch eine Summierung der Phasengrob- und Phasenfeindifferenz bestimmt ist.

4. Verfahren nach einem der Ansprüche 1 bis 3,
dadurch **gekennzeichnet**,
daß die durch die Takt- oder Referenztaktsignale (ts,rts) bestimmten Zeitpunkte durch die negativen oder positiven Flanken der Taktsignale (ts) bzw. Referenztaktsignale (rts) repräsentiert sind.

5. Anordnung zum Ermitteln der Phasendifferenz zwischen einem Taktsignal (ts) und einem Referenztaktsignal (rts),
- mit einer die Taktsignale (ts) zählenden Zähleinrichtung (ZE), wobei jedes Zählergebnis durch einen Zählerstand (zs) repräsentiert ist,
- mit einem jeweils den aktuellen Zählerstand (zs) zu durch auf die Taktsignale (ts) synchronisierten Referenztaktsignale (rts) bestimmten Zeitpunkten übernehmenden Zählregister (ZR),
- mit einer von den Referenztaktsignalen (rts) durchlaufenen, durch hintereinandergeschaltete Verzögerungselemente (VE) gebildeten Verzögerungsleitung (VZL),
- mit einem jeweils zu durch das folgende Taktsignal (ts) bestimmten Zeitpunkten eine die Anzahl der vom Referenztaktsignal (rts) durchlaufenen Verzögerungselemente (VE) repräsentierende Laufzeitinformation (cd') übernehmenden Laufzeitregister (LZR),
dadurch **gekennzeichnet**,
- daß ein eine weitere, die Anzahl während einer Periode des Taktsignals (rts) durchlaufenen Verzögerungselemente (VE) repräsentierende Laufzeitinformation (wcd) übernehmendes, weiteres Laufzeitregister (WLZR) vorgesehen ist,
- daß ein Mikroprozessor (MP) derart ausgestaltet ist,
-- daß mit Hilfe der weiteren Laufzeitinformationen (wcd) und der Dauer einer Periode des Taktsignals (ts) die absolute Laufzeit eines Verzögerungselementes (VE) ermittelt wird,
-- daß mit Hilfe der absoluten Laufzeit eines Verzögerungselementes (VE) die absolute Laufzeitinformation (cd') ermittelt wird, und
-- daß mit Hilfe des gespeicherten Zählerstandes (zs) und der absoluten Laufzeitinformation (cd') die Phasendifferenz ermittelt wird.

## Claims

1. Method for determining the phase difference between a clock signal (ts) and a reference clock signal (rts),
- in which the clock signals (ts) are counted in a counting device (ZE),
- in which in each case the current counter content (zs) is taken over into a counting register (ZR) at instants determined by the reference clock signals (rts) and synchronized with the clock signals (ts),
- in which the reference clock signals (rts) traverse serially connected elements (VE) of a delay line (VZL)
- in which an item of delay-time information (cd') representing the number of delay elements (VE) traversed by the reference clock signal (rts) is taken over into a delay-time register (LZR) at instants determined by the following clock signal (ts) in each case,
characterized
- in that a further item of time-delay information (wcd) representing the number of delay elements (VE) traversed during one period of the clock signal (rts) is taken over into a further delay-time register (WLZR)
- in that the absolute delay time of a delay element (VE) is determined with the aid of a further item of delay-time information (wcd) and of the duration of a period of the clock signal (ts),
- in that the absolute delay-time information (cd') is determined with the aid of the absolute delay time of a delay element (VE) and
- in that the phase difference is determined with the aid of the stored counter content (zs) and the absolute delay-time information (cd').

2. A method according to Claim 1, characterized in that the absolute delay time of a delay element (VE) is determined by dividing the prescribed duration of the period of a clock signal (ts) by the number of delay elements (VE) represented by the further delay-time information (wcd).

3. Method according to Claim 1 or 2, characterized
- in that the coarse phase difference are represented by periods of the clock signal (ts), of a clock signal (ts) relative to a reference clock signal (rts) is determined by subtracting the current counter content (zs) from the preceding one,
- in that the phase difference within a period of the clock signal (ts) is determined by multiplying the absolute delay time of a delay element (VE) by the number of delay elements (VE) represented by the delay-time information (cd'), and
- in that the phase difference between the clock signals (ts) and the reference clock signals (rts) is determined in each case by summing the course phase difference and fine phase difference.

4. Method according to one of Claims 1 to 3, characterized in that the instants determined by the clock or reference clock signals (ts, rts) are represented by the negative or positive edges of the clock signals (ts) and reference clock signals (rts), respectively.

5. Arrangement for determining the phase difference between a clock signal (ts) and a reference clock signal (rts),
- having a counting device (ZE) counting the clock signals (ts), each counting result being represented by a counter content (zs)
- having a counting register (ZR) which takes over from the current counter content (zs) in each case at instances determined by reference clock signals (rts) synchronized with the clock signals (ts),
- having a delay line (VZL) which is traversed by the reference clock signals (rts) and formed by serially connected delay elements (VE), and
- having a delay-time register (LZR) which takes over an item of delay-time information (cd') representing the number of the delay elements (VE) traversed by the reference clock signal (rts) at instances specified by the following clock signal (ts) in each case,
characterized
- in that a further item of time-delay information (wcd) representing the number of delay elements (VE) traversed during one period of the clock signal (rts) is taken over into a further delay-time register (WLZR)
- in that a microprocessor (MP) is designed such that
- the absolute delay time of a delay element (VE) is determined with the aid of a further item of delay-time information (wcd) and of the duration of a period of the clock signal (ts),
- the absolute delay-time information (cd') is determined with the aid of the absolute delay time of a delay element (VE) and
- the phase difference is determined with the aid of the stored counter content (zs) and the absolute delay-time information (cd').

## Revendications

1. Procédé de détermination de la différence de phase entre un signal d'horloge (ts) et un signal d'horloge de référence (rts), dans lequel
- on compte les signaux d'horloge (ts) dans un dispositif compteur (ZE),
- on reçoit dans un registre de comptage (ZR), à chaque fois à des instants déterminés par les signaux d'horloge de référence (rts) et synchronisés sur les signaux d'horloge (ts), l'état de comptage (zs) actuel,
- les signaux d'horloge de référence (rts) traversent des éléments à retard (VE), branchés en cascade, d'une ligne à retard (VZL),
- on reçoit dans un registre de temps de propagation (LZR), à chaque fois à des instants déterminés par le signal d'horloge (ts) suivant, une information de temps de propagation (cd') représentant le nombre des éléments à retard (VE) traversés par le signal d'horloge de référence (rts),
caractérisé par le fait que
- l'on reçoit dans un registre de temps de propagation supplémentaire (WLZR) une autre information de temps de propagation (wcd) représentant le nombre des éléments à retard (VE) traversés pendant une période du signal d'horloge (ts),
- l'on détermine le temps de propagation absolu d'un élément à retard (VE) à l'aide des autres informations de temps de propagation (wcd) et de la durée d'une période du signal d'horloge (ts),
- l'on détermine l'information de temps de propagation absolue (cd') à l'aide du temps de propagation absolu d'un élément à retard (VE), et que
- l'on détermine la différence de phase à l'aide de l'état de comptage (zs) mémorisé et de l'information de temps de propagation absolue (cd').

2. Procédé selon la revendication 1,
caractérisé par le fait que
le temps de propagation absolu d'un élément à retard (VE) est déterminé par une division de la durée prédéterminée de la période d'un signal d'horloge (ts) par le nombre, représenté par l'autre information de temps de propagation (wcd), des éléments à retard (VE).

3. Procédé selon la revendication 1 ou 2,
caractérisé par le fait que
- la différence approximative de phase, représentée par des périodes du signal d'horloge (ts), d'un signal d'horloge (ts) à un signal d'horloge de référence (rts) est déterminée par la soustraction entre l'état de comptage (zs) actuel et précédent,
- la différence précise de phase à l'intérieur d'une période du signal d'horloge (ts) est déterminée par la multiplication du temps de propagation absolu d'un élément à retard (VE) par le nombre, représenté par l'information de temps de propagation (cd'), d'éléments à retard (VE), et que
- la différence de phase entre les signaux d'horloge (ts) et les signaux d'horloge de référence (rts) est déterminée à chaque fois par une addition de la différence approximative de phase et de la différence précise de phase.

4. Procédé selon l'une des revendications 1 à 3,
caractérisé par le fait que
les instants déterminés par les signaux d'horloge (ts) ou par les signaux d'horloge de référence (rts) sont représentés par les fronts négatifs ou positifs des signaux d'horloge (ts) ou des signaux d'horloge de référence (rts).

5. Dispositif pour déterminer la différence de phase entre un signal d'horloge (ts) et un signal d'horloge de référence (rts),
- avec un dispositif compteur (ZE) comptant les signaux d'horloge (ts), chaque résultat de comptage étant représenté par un état de comptage (zs),
- avec un registre de comptage (ZR) recevant l'état de comptage (zs) actuel à chaque fois à des instants déterminés par des signaux d'horloge de référence (rts) synchronisés sur les signaux d'horloge (ts),
- avec une ligne à retard (VZL) formée par des éléments à retard (VE) branchés en cascade et traversée par les signaux d'horloge de référence (rts),
- avec un registre de temps de propagation (LZR) recevant à chaque fois à des instants déterminés par le signal d'horloge (ts) suivant une information de temps de propagation (cd') représentant le nombre des éléments à retard (VE) traversés par le signal d'horloge de référence (rts),
caractérisé par le fait que
- il est prévu un registre de temps de propagation supplémentaire (WLZR) recevant une autre information de temps de propagation (wcd) représentant le nombre des éléments à retard (VE) traversés pendant une période du signal d'horloge (ts),
- un microprocesseur (MP) est conçu de telle sorte que
-- le temps de propagation absolu d'un élément à retard (VE) est déterminé à l'aide de l'autre information de temps de propagation (wcd) et de la durée d'une période du signal d'horloge (ts),
-- l'information de temps de propagation absolue (cd') est déterminée à l'aide du temps de propagation absolu d'un élément à retard (VE), et que
-- la différence de phase est déterminée à l'aide de l'état de comptage (zs) mémorisé et de l'information de temps de propagation absolue (cd').
